(19) Europäisches Patentamt
European Patent Office
Office européen des brevets

(11) **EP 3 121 611 A1**

(12) **EUROPEAN PATENT APPLICATION**

(43) Date of publication:
**25.01.2017 Bulletin 2017/04**

(51) Int Cl.:
**G01R 31/06** *(2006.01)*     *G01R 31/317* *(2006.01)*
**H03K 3/42** *(2006.01)*

(21) Application number: **16180178.2**

(22) Date of filing: **19.07.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **20.07.2015 US 201514803790**

(71) Applicant: **Tektronix, Inc.**
**Beaverton, Oregon 97077-0001 (US)**

(72) Inventor: **PEETERS WEEM, Jan**
**Forest Grove, OR 97116 (US)**

(74) Representative: **Clarke, Jeffrey David**
**HGF Limited**
**Fountain Precinct**
**Balm Green**
**Sheffield S1 2JA (GB)**

(54) **TIME CORRECTED TIME-DOMAIN REFLECTOMETER**

(57)     A test and measurement instrument including an input configured to receive a reflected and/or transmitted pulse signal from a device under test, a reference clock input configured to receive a reference signal, the reference signal being asynchronous from the reflected pulse signal, a phase reference module configured to acquire samples of the reference signal, a sampling module configured to acquire samples of the reflected pulse signal; and a controller configured to determine a scattering parameter of the device under test based on the acquired samples of the reference signal and the acquired samples of the reflected pulse signal.

FIG. 1

**EP 3 121 611 A1**

**Description**

TECHNICAL FIELD

This disclosure relates to determining the reflection coefficients, transmission coefficients, and scattering parameters of an unknown device under test using an asynchronous phase reference, fast impulse, and an electrical sampling scope.

BACKGROUND

Test and measurement systems with time domain solutions are limited. Currently, time domain reflectometers and transmitometers are only useable up to approximately 50 GHz. Vector network analyzers, while having higher bandwidths, are extremely expensive.

Embodiments of the disclosed technology address these and other limitations in the prior art.

SUMMARY

Some embodiments of the disclosed technology are directed toward a test and measurement instrument, including an input configured to receive a reflected or transmitted pulse signal from a device under test; a reference clock input configured to receive a reference signal, the reference signal being asynchronous from the reflected pulse signal; a phase reference module configured to acquire samples of the reference signal; a sampling module configured to acquire samples of the reflected and/or the transmitted pulse signal; and a controller configured to determine the reflection and transmission coefficients of the device under test based on the acquired samples of the reference signal and the acquired samples of the reflected and/or transmitted pulse signals.

Some embodiments of the disclosed technology are directed toward a method for determining scattering parameters of a device under test, including receiving a reflected pulse signal from a device under test; receiving a transmitted pulse from a device under test; receiving a reference signal, the reference signal being asynchronous from the reflected pulse signal; acquiring samples of the reference signal; acquiring samples of the transmitted and/or reflected pulse signals; and determining a scattering parameter of the device under test based on the acquired samples of the reference signal and the acquired samples of the reflected pulse signal.

BRIEF DESCRIPTION OF THE DRAWINGS

Figure 1 illustrates an arrangement of test and measurement equipment suitable for implementing an acquisition method of the disclosed technology.
Figure 2 depicts a method for determining the scattering parameter of a device under test using the disclosed technology.
Figure 3 shows a full scale of the calculated impulse and sampled data using the method of Figure 2.
Figure 4 shows a zoomed in region where ripples are still visible in the impulse response of the calculated impulse and sampled data using the method of Figure 2.
Figure 5 shows a zoomed in region of the main pulse of the calculated impulse and sampled data using the method of Figure 2.
Figure 6 illustrates an arrangement of test and measurement equipment suitable for implementing an acquisition method of the disclosed technology when the device under test has multiple input and output ports.

DETAILED DESCRIPTION

In the drawings, which are not necessarily to scale, like or corresponding elements of the disclosed systems and methods are denoted by the same reference numerals.

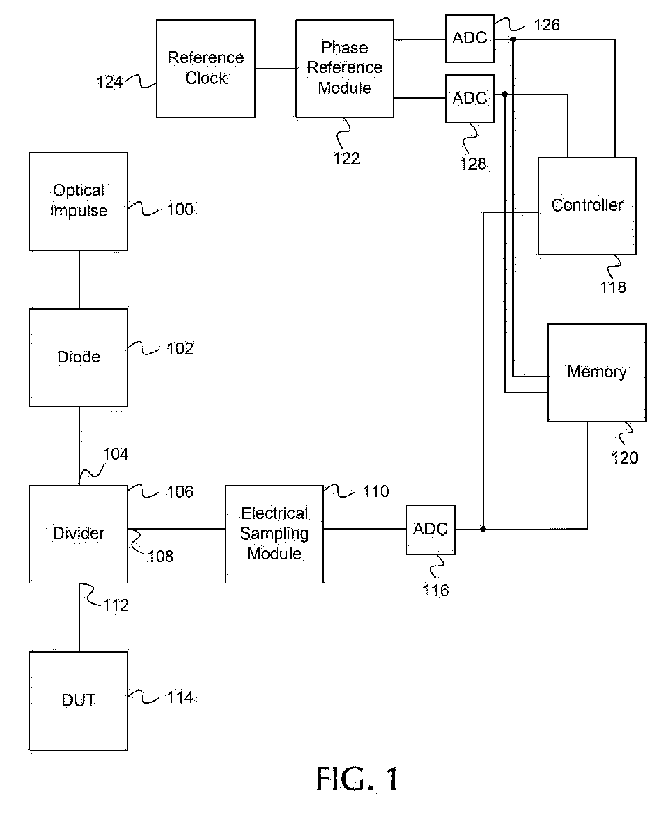

Figure 1 depicts an arrangement of a test and measurement system with an electrical sampling module in accordance with the disclosed technology. A pulse source 100 is connected to a high-speed photo diode 102. The pulse source 100 is preferably an optical pulse source such as, for example, a Calmar Mode Locked Laser. Other types of pulse sources may be used to provide the pulse. The pulse source, however, should be highly stable. The photo diode 102 is connected to one port 104 of a resistive divider 106. The second port 108 of the resistive divider 106 is connected to an electrical sampling module 110. The third port 112 of the resistive divider 106 is connected to either a device under test (DUT) 114 or the calibration standards (when performing calibrations).

The output from the sampling module 110 is sent to an analog-to-digital (ADC) converter 116 to digitize the sampled outputs from the sampling module 110 and are passed to a controller 118 for further processing, discussed below, and for storage in memory 120. The controller 118 may be a general purpose processor with software, a microcontroller, an ASIC, an FPGA, etc.

A phase reference module 122 is also provided that receives a reference clock 124 signal. The reference clock 124 is preferably a highly stable reference frequency. The reference clock 124 is preferably a sine-wave. The sine-wave is spectrally pure, meaning that it has low phase-noise, or equivalently, that it has low jitter. The frequency of the reference clock 124 is not critical for reasons discussed below. The reference clock 124 may be internal or external to the test and measurement instrument.

The phase reference module 122 internally splits the reference clock into two replicas, and samples them at quadrature, or 90° apart, to produce one pair of sampled analog values per sample. Analog-to-digital converters (ADC) 126 and 128 digitize the sampled analog values from the phase reference module 122. These digitized sampled values are sent to controller 118 and memory 120 for processing and storage, respectively. Because both the pulse source 100 and the reference clock 124 are highly stable, the phase between the two devices should drift linearly with respect to each other. So any phase difference that deviates from the measured linear drift between the two is caused by the time-base of the measurement system and can be corrected, as discussed in more detail below.

Calibration coefficients are determined and stored in the memory 120 for processing the signals from the DUT 114. To determine the calibration coefficients, measurements are determined when port three 112 of the divider 106 is terminated using three known terminations, usually open, shorted, and 50 Ohm load. The same procedure described below with respect to the DUT 114 is performed to determine the calibration standards when port three 112 of the resistive divider 106 is open, shorted, or connected to a known load. This may be done, for example, at regular time intervals and stored in the memory 120.

During operation, the pulse source 100 sends a pulse signal through the diode 102 to the resistive divider 106. The resistive divider 106 then divides the signal to be sent to the DUT 114 (or the calibration standards during calibration) and the sampling module 110. The sampling module 110 receives the impulse signal from the resistive divider and also receives a reflected signal of the impulse signal received at the DUT 114 back through the resistive divider 106. That is, the impulse signal is reflected from the DUT 114 and also received at the sampling module 110. This measured signal is used to calculate the reflection coefficient, S11, of the DUT 114 without the use of a vector network analyzer. The reflection coefficient may then be de-embedded from received signals of the DUT for other calculations by the test and measurement instrument.

The impulses of four different test signals are measured over a time period T. This time period includes the original impulse, as well as the reflected signal coming from the DUT 114 or the calibration standards. Although the original impulse does not strictly need to be measured, such a measurement makes aligning the reflected signal easier. For each impulse measurement, the phase-reference module 122 must also be used to capture the reference signal from the reference clock 124. That is, during time period T, the reflected test signals are measured as well as the reference signal from the reference clock 124.

Preferably, multiple acquisitions of each of the four measurements should be taken. The more data that is received, the lower the noise level present in the post processed waveform.

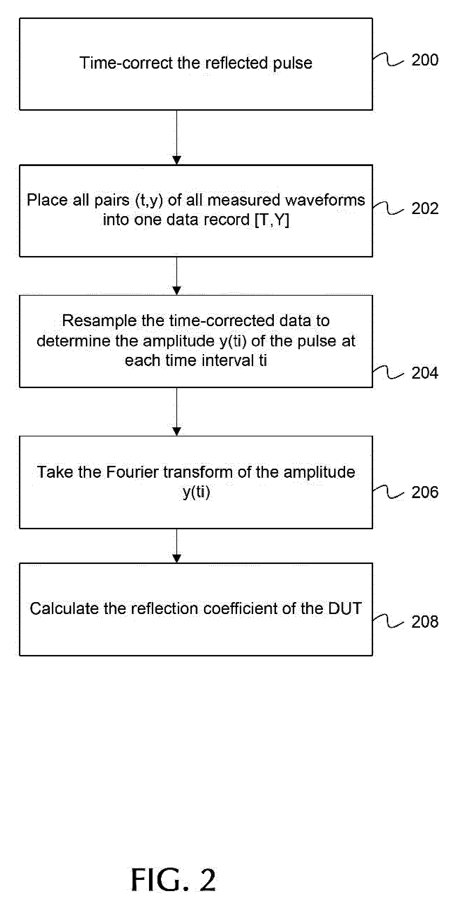

Figure 2 depicts the method for determining the reflection coefficient of the DUT 114.

In step 200, all of the measured impulses are corrected for time-based errors using an asynchronous correction algorithm, an example of which is discussed in U.S. Patent No. 7,746,058, titled SEQUENTIAL EQUIVALENT - TIME SAMPLING WITH AN ASYNCHRONOUS REFERENCE CLOCK, filed March 21, 2008, which is incorporated herein by reference in its entirety.

That is, the impulse and phase of the reference clock signal are measured during time period T. The in-phase and quadrature components of the reference clock signal are plotted. The resulting Lissajou is fit with an ellipse to calculate the phase. Since the phase has a linear progression, it is unwrapped and the phase data is fitted with a line. Deviations from the line is the jitter present in the system. By converting radians to seconds, the signal received by the sampling module 110 can be time-corrected based on the deviations from the line.

The time-corrected data is now no longer uniformly spaced. Each point has its own unique timestamp. The time-corrected pulse is then resampled to be uniformly spaced. To do this, the time-corrected pulses of the signal received by the sampling module 110 are aligned by fitting the initial pulse with a Gaussian function. The location of the center of the Gaussian function is used as the reference point to realign the data. As mentioned above, because the corrections of the time base shift the sample locations in time, the impulse data no longer has uniformly spaced sampled points. This needs to be corrected, so the Fourier transform can be taken in the next step. The multiple acquisition are then averaged together to reduce the noise. The averaging and resampling of the time base may be performed by taking a numerical convolution of the data with a Gaussian impulse, as described in more detail below.

In operation 202, all the pairs (t,y) of all the measured waveforms are placed into one data record [T,Y]. The vector T consists of non-uniformly spaced time points and the vector Y consists of the amplitude data. A uniformly spaced sampling grid, t = {t0, t1, t2, ..., ti}, is chosen, where ti=i*Δt.

For each time interval ti, the integral

$$y(ti) = \frac{1}{\sigma\sqrt{\pi}} \int_{-\infty}^{\infty} Y(\tau) e^{\frac{-(\tau-ti)^2}{\sigma^2}} d\tau$$ is computed in

operation 204 to determine the amplitude of the pulse at each time interval ti to resample the data. This is a convolution of a function (Y) with Gaussian impulse. The value σ determines the rise-time of the impulse. This integral acts as the averaging over the data. Using a Gaussian function also makes the bandwidth calculations easier. Since the function Y is sampled Yi, the integral needs to be computed numerically. For small rise-times, the tails of the Gaussian decay rapidly and only a small region of integration needs to be used, which results in an increase speed in computation.

By choosing the rise-time of the Gaussian, the filter bandwidth can be adjusted to have minimal impact on the measured data so that y(ti)≈Y(ti), i.e., the smaller the rise-time, the larger the effective bandwidth of the filter. There is a practical limit, however, in that if the rise-time is made too small, then the filter becomes too narrow and not enough sampled data is used for any given point. This results in a noisy looking plot because not enough of the noise has been averaged out.

In operation 206, the Fast Fourier Transform (FFT) is taken of Yi.

Correcting the time base, resampling, and averaging the data produces one uniform time vector and four impulse measurement amplitude vectors, where the three calibration vectors may be stored from a previous measurement. For the calibration step the FFT is taken so the data is in the frequency domain. Since the calibration standards are pre-stored in the memory 120, as discussed above, only the reflection coefficient of the DUT 114 is unknown. Standard calibration correction algorithms in the frequency domain may be used to correct the measurement of the DUT 114. These algorithms use the pre-measured calibration standards to correct for unknown distortions in the measurement system.

To calculate the actual reflection based on a non-ideal measurement in opeation 208, three known reference standards are used, usually a short, open and load. The reflection coefficient of each of these standards is known so the measured reflection can be compared to the actual reflection for each of the calibration standards. In one port DUT Network Analysis there are three error terms, usually referred to as source match, directivity and reflection tracking errors. Three equations are set up, comparing the known standards to the measure results, where each of these three equations has three unknowns (directivity, source match and reflection tracking). The three equations are solved for the three unknowns and use them to correct for the s-parameters of the DUT.

Therefore, the S11 S-parameter, the reflection coefficient, is determined using an electrical sampling scope, rather than a vector network analyzer. The above-discussed method and system may also be used to measure a transmitted signal from a DUT, rather than a reflected signal.

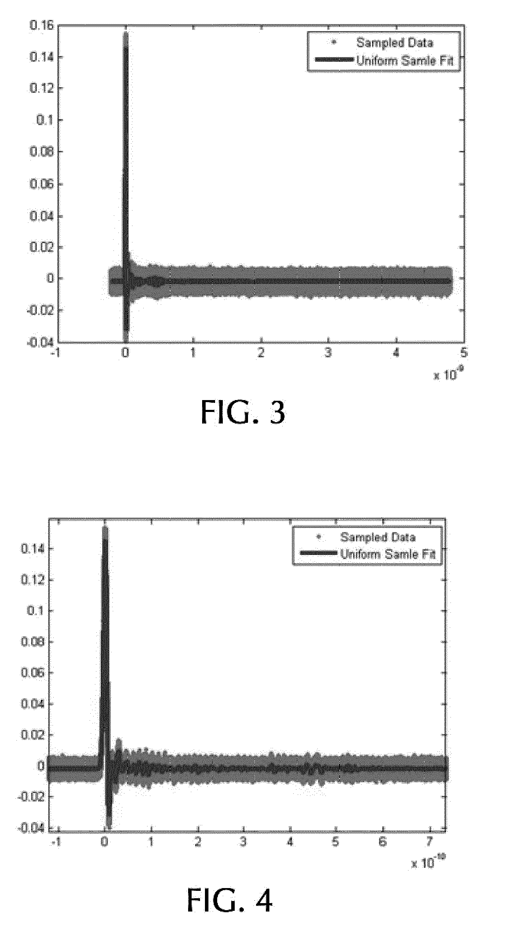

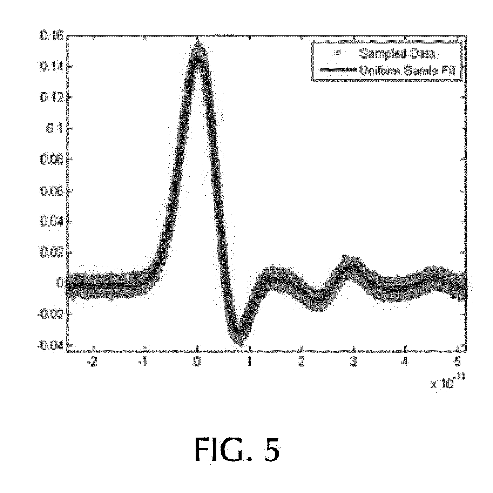

Figures 3-5 show the calculated impulse using the method of Figure 2. For this method, a convolution rise-time of 0.5pS was chosen. This corresponds to a filter that has a loss of only 0.05dB at 100GHz, so the impact of the convolution is quite small over the bandwidth of interest.

The above-discussed disclosed technology is not limited to measuring a single port. The above systems and methods can be extended to measure the scattering parameters of a multiple port DUT. To extend the above-discussed method and systems to multiple ports, the method discussed above would be performed for each port.

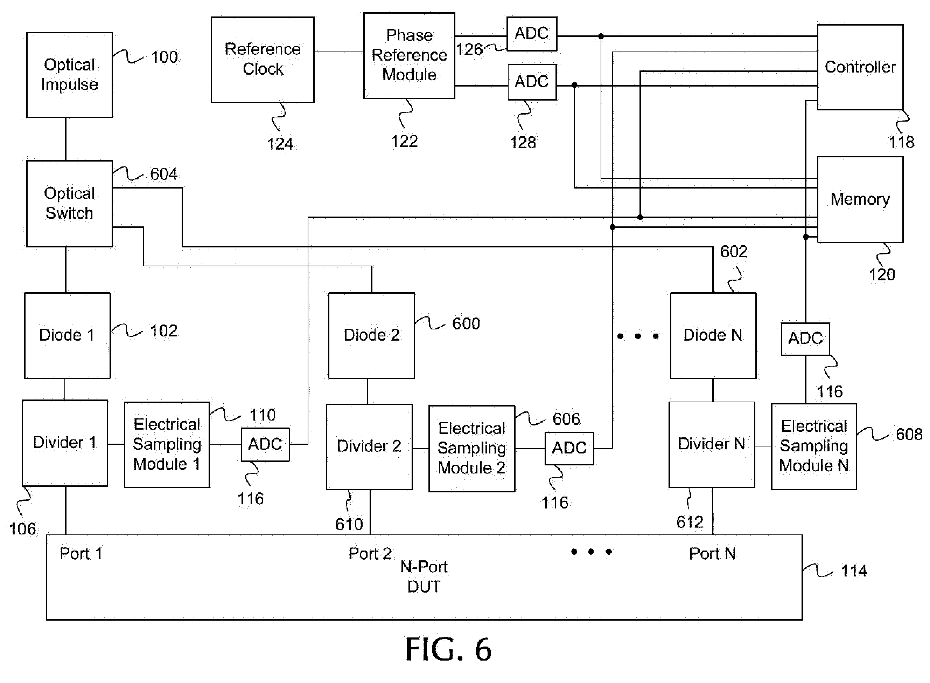

For multiport scattering parameters one possible setup would be as shown in Figure 6. Here the impulse laser is routed to the N-photo-diodes 102, 600, 602 using an optical switch 604. Each of the diodes 102, 600, 602 is connected to the DUT 114 and, a divider 106, 610, 612, and a sampler 110, 606, and 608, respectively, as in the one-port case. The reflection coefficients, as before, are determined by measuring the impulse at the nth sampler 608 when the optical pulse is incident on the nth diode 602. The transmission coefficient can also be measured from port n-1 to port n by measuring the n-1 sampler 606 when the pulse is incident on the nth diode 602. For each port a reflection calibration and through calibration needs to be made. A modification needs to be made to the calibration method, when before three known reflections (short, open and load) were used, now a known through is used. The through needs to be measured from each of the n-ports to the other n-1 ports. The calibration is as before where the errors are solved for by solving a system of equations.

Examples provide a test and measurement instrument, comprising an input configured to receive a reflected or transmitted pulse signal from a device under test, a reference clock input configured to receive a reference signal, the reference signal being asynchronous from the reflected pulse signal, a phase reference module configured to acquire samples of the reference signal, a sampling module configured to acquire samples of the reflected pulse signal, and a controller configured to determine a scattering parameter of the device under test based on the acquired samples of the reference signal and the acquired samples of the reflected pulse signal.

Some examples further comprise a pulse source configured to output the pulse signal to the device under test.

Some examples further comprise a divider configured to receive the pulse signal from the pulse source and output the pulse signal to the sampling module and the device under test.

In some examples the pulse source is an optical pulse source.

In some examples the controller is configured to determine the scattering parameter of the device under test by time-correcting the acquired samples of the reflected pulse signal by calculating sampled phases from the acquired samples of the reference signal, unwrapping the sampled phases into a sampled phase ramp, generating an ideal phase ramp from the sampled phase ramp, subtracting the sampled phase ramp from the ideal phase ramp to calculate timestamps from the acquired samples of the reference signal, and time-correcting the acquired samples of the reflected pulse signal based on the calculated timestamps.

In some examples the controller is configured to determine the scattering parameter of the device under test by resampling the time-corrected acquired samples of the reflected pulse to be uniformly spaced using the following equation:

$$y(ti) = \frac{1}{\sigma\sqrt{\pi}} \int_{-\infty}^{\infty} Y(\tau)e^{\frac{-(\tau-ti)^2}{\sigma^2}} d\tau,$$

where y(ti) is the amplitude of the pulse at time ti, $\sigma$ is a rise-time of the pulse, and $\Delta$t is the time between intervals ti and ti-1.

In some examples the controller is further configured to transform y(ti) into the frequency domain.

Some examples further comprise a memory configured to store calibration coefficients, wherein the controller is further configured to determine the scattering parameters of the device under test based on the calibration coefficients.

Examples provide a method for determining a scattering parameter of a device under test, comprising receiving a reflected pulse signal from a device under test, receiving a reference signal, the reference signal being asynchronous from the reflected pulse signal, acquiring samples of the reference signal, acquiring samples of the reflected pulse signal, and determining a scattering parameter of the device under test based on the acquired samples of the reference signal and the acquired samples of the reflected pulse signal.

Some examples further comprise outputting the pulse signal to the device under test.

Some examples further comprise outputting the pulse signal to the sampling module and the device under test via a divider.

In some examples the pulse signal is an optical pulse signal.

In some examples, determining the scattering parameter of the device under test by time-correcting the acquired samples of the reflected pulse signal includes calculating sampled phases from the acquired samples of the reference signal, unwrapping the sampled phases into a sampled phase ramp, generating an ideal phase ramp from the sampled phase ramp, subtracting the sampled phase ramp from the ideal phase ramp to calculate timestamps from the acquired samples of the reference signal, and time-correcting the acquired samples of the reflected pulse signal based on the calculated timestamps.

In some examples, determining the scattering parameter of the device under test includes resampling the time-corrected acquired samples of the reflected pulse to be uniformly spaced using the following equation:

$$y(ti) = \frac{1}{\sigma\sqrt{\pi}} \int_{-\infty}^{\infty} Y(\tau)e^{\frac{-(\tau-ti)^2}{\sigma^2}} d\tau,$$

where y(ti) is the amplitude of the pulse at time ti, $\sigma$ is a rise-time of the pulse, and $\Delta$t is the time between intervals ti and ti-1.

Some examples further comprise transforming y(ti) into the frequency domain.

Having described and illustrated the principles of the disclosed technology in a preferred embodiment thereof, it should be apparent that the disclosed technology can be modified in arrangement and detail without departing from such principles. I claim all modifications and variations coming within the scope of the following claims.

## Claims

1. A test and measurement instrument, comprising:

   an input configured to receive a reflected or transmitted pulse signal from a device under test;
   a reference clock input configured to receive a reference signal, the reference signal being asynchronous from the reflected pulse signal;
   a phase reference module configured to acquire samples of the reference signal;
   a sampling module configured to acquire samples of the reflected pulse signal; and
   a controller configured to determine a scattering parameter of the device under test based on the acquired samples of the reference signal and the acquired samples of the reflected pulse signal.

2. The test and measurement instrument of claim 1, further comprising a pulse source configured to output the pulse signal to the device under test.

3. The test and measurement instrument of claim 2, further comprising a divider configured to receive the pulse signal from the pulse source and output the pulse signal to the sampling module and the device under test.

4. The test and measurement instrument of claim 2 or 3, wherein the pulse source is an optical pulse source.

5. The test and measurement instrument of any of claims 1 to 4, wherein the controller is configured to determine the scattering parameter of the device under test by time-correcting the acquired samples of the reflected pulse signal by:

   calculating sampled phases from the acquired samples of the reference signal,
   unwrapping the sampled phases into a sampled phase ramp,
   generating an ideal phase ramp from the sampled phase ramp,
   subtracting the sampled phase ramp from the ideal phase ramp to calculate timestamps from the acquired samples of the reference signal;

and

time-correcting the acquired samples of the reflected pulse signal based on the calculated timestamps.

6. The test and measurement instrument of claim 5, wherein the controller is configured to determine the scattering parameter of the device under test by resampling the time-corrected acquired samples of the reflected pulse to be uniformly spaced using the following equation:

$$y(ti) = \frac{1}{\sigma\sqrt{\pi}} \int_{-\infty}^{\infty} Y(\tau) e^{\frac{-(\tau-ti)^2}{\sigma^2}} d\tau,$$

where

y(ti) is the amplitude of the pulse at time ti,
$\sigma$ is a rise-time of the pulse,
and $\Delta$t is the time between intervals ti and ti-1.

7. The test and measurement instrument of claim 6, wherein the controller is further configured to transform y(ti) into the frequency domain.

8. The test and measurement instrument of any of claims 1 to 7, further comprising a memory configured to store calibration coefficients, wherein the controller is further configured to determine the scattering parameters of the device under test based on the calibration coefficients.

9. A method for determining a scattering parameter of a device under test, comprising:

receiving a reflected pulse signal from a device under test;
receiving a reference signal, the reference signal being asynchronous from the reflected pulse signal;
acquiring samples of the reference signal;
acquiring samples of the reflected pulse signal; and
determining a scattering parameter of the device under test based on the acquired samples of the reference signal and the acquired samples of the reflected pulse signal.

10. The method of claim 9, further comprising outputting the pulse signal to the device under test.

11. The method of claim 10, further comprising outputting the pulse signal to the sampling module and the device under test via a divider.

12. The method of claim 10 or 11, wherein the pulse signal is an optical pulse signal.

13. The method of any of claims 9 to 12, wherein determining the scattering parameter of the device under test by time-correcting the acquired samples of the reflected pulse signal includes:

calculating sampled phases from the acquired samples of the reference signal,
unwrapping the sampled phases into a sampled phase ramp,
generating an ideal phase ramp from the sampled phase ramp,
subtracting the sampled phase ramp from the ideal phase ramp to calculate timestamps from the acquired samples of the reference signal, and
time-correcting the acquired samples of the reflected pulse signal based on the calculated timestamps.

14. The method of claim 13, wherein determining the scattering parameter of the device under test includes resampling the time-corrected acquired samples of the reflected pulse to be uniformly spaced using the following equation:

$$y(ti) = \frac{1}{\sigma\sqrt{\pi}} \int_{-\infty}^{\infty} Y(\tau) e^{\frac{-(\tau-ti)^2}{\sigma^2}} d\tau,$$

where

y(ti) is the amplitude of the pulse at time ti,
$\sigma$ is a rise-time of the pulse,
and $\Delta$t is the time between intervals ti and ti-1.

15. The method of claim 14, further comprising transforming y(ti) into the frequency domain.

FIG. 1

Time-correct the reflected pulse — 200

Place all pairs (t,y) of all measured waveforms into one data record [T,Y] — 202

Resample the time-corrected data to determine the amplitude y(ti) of the pulse at each time interval ti — 204

Take the Fourier transform of the amplitude y(ti) — 206

Calculate the reflection coefficient of the DUT — 208

# FIG. 2

FIG. 3

FIG. 4

FIG. 5

FIG. 6

Europäisches
Patentamt

European
Patent Office

Office européen
des brevets

**EUROPEAN SEARCH REPORT**

Application Number

EP 16 18 0178

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 8 841 923 B1 (VANWIGGEREN GREGORY DOUGLAS [US]) 23 September 2014 (2014-09-23) * figure 9 * * figure 10 * * column 6, line 20 - column 8, line 34 * * column 14, line 43 - line 58 * * column 15, line 61 - column 20, line 8 * ----- | 1,2,4, 8-10,12 | INV. G01R31/06  ADD. G01R31/317 H03K3/42 |
| Y | Unknown:  "DSA8200 Digital Serial Analyzer Quick Start User Manual", , 21 May 2009 (2009-05-21), XP055324953, Retrieved from the Internet: URL:http://www.tek.com/oscilloscope/80e06-manual/dsa8200-manual/dsa8200 [retrieved on 2016-12-01] * page 1 * * page 58 * * page 60 * * page 75 * ----- | 1-15 | |
| Y,D | US 7 746 058 B2 (NELSON MICHAEL A [US] ET AL) 29 June 2010 (2010-06-29) * figure 1 * * figure 2 * * column 1, line 7 - line 19 * * column 1, line 68 - column 2, line 29 * * column 3, line 3 - column 5, line 12 * ----- -/-- | 1-15 | TECHNICAL FIELDS SEARCHED (IPC)  G01R H03K |

The present search report has been drawn up for all claims

| Place of search | Date of completion of the search | Examiner |
|---|---|---|
| Munich | 2 December 2016 | Nguyen, Minh |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

Europäisches
Patentamt

European
Patent Office

Office européen
des brevets

**EUROPEAN SEARCH REPORT**

Application Number

EP 16 18 0178

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | Unknown: "User's Guide PicoScope 9300 Series", <br> , <br> 2 July 2015 (2015-07-02), page I-V, 15-17, 36-38, 383-395, XP055325084, <br> Retrieved from the Internet: <br> URL:https://www.picotech.com/download/manuals/PicoScope9300SeriesUsersGuide.pdf <br> [retrieved on 2016-12-01] <br> * page 15 - page 17 * <br> * page 36 - page 38 * <br> * page 383 - page 395 * <br> ----- | 1-3,9-11 | |
| A | PAVEL ZIVNY: "Recommendations for TDR configuration for channel characterization by S-parameters", <br> IEEE DRAFT; ZIVNY_01A_0311, IEEE-SA, PISCATAWAY, NJ USA, <br> vol. 802.3bj;802.3.100GCU, <br> 26 June 2011 (2011-06-26), pages 1-14, XP068010550, <br> [retrieved on 2011-06-26] <br> * the whole document * <br> ----- | 1,9 | |
| A | Himanshu Maggo: "Measuring S-Parameters using DSA 8200 by Tektronix", <br> youtube, <br> 22 March 2015 (2015-03-22), page 1 pp., XP054976964, <br> Retrieved from the Internet: <br> URL:https://www.youtube.com/watch?v=LAo1A17rLkA <br> [retrieved on 2016-12-01] <br> * the whole document * <br> ----- | 1,9 | TECHNICAL FIELDS SEARCHED (IPC) |
| A | US 2009/208220 A1 (LAGASSE MICHAEL J [US]) 20 August 2009 (2009-08-20) <br> * abstract * <br> ----- | 4 | |

The present search report has been drawn up for all claims

| Place of search | Date of completion of the search | Examiner |
|---|---|---|
| Munich | 2 December 2016 | Nguyen, Minh |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 18 0178

This annex lists the patent family members relating to the patent documents cited in the above-mentioned European search report.
The members are as contained in the European Patent Office EDP file on
The European Patent Office is in no way liable for these particulars which are merely given for the purpose of information.

02-12-2016

| Patent document cited in search report | | Publication date | Patent family member(s) | Publication date |
|---|---|---|---|---|
| US 8841923 | B1 | 23-09-2014 | NONE | |
| US 7746058 | B2 | 29-06-2010 | NONE | |
| US 2009208220 | A1 | 20-08-2009 | NONE | |

EPO FORM P0459

For more details about this annex : see Official Journal of the European Patent Office, No. 12/82

**EP 3 121 611 A1**

## REFERENCES CITED IN THE DESCRIPTION

**Patent documents cited in the description**

- US 7746058 B